# EUROPEAN PATENT SPECIFICATION

(11) **EP 1 582 294 B1**
(45) Date of publication and mention of the grant of the patent: **21.03.2012**
(21) Application number: 05252050.9
(22) Date of filing: 31.03.2005
(51) Int. Cl.: B24B 37/04, B24B 55/12, B24B 55/02

(54) **Wafer polishing method.**
Verfahren zum Polieren von Halbleitern
Procédé de polissage pour plaquette.

(30) Priority: 31.03.2004 JP 2004104535; 28.02.2005 JP 2005053148
(43) Date of publication of application: 05.10.2005
(73) Proprietor: Fujikoshi Machinery Corporation, Nagano-shi, Nagano 381-1233 (JP)
(72) Inventor: Nakamura, Yoshio Fujikoshi Machinery Corp., Nagano-shi Nagano 381-1233 (JP); Hashizume, Kenji Fujikoshi Machinery Corp., Nagano-shi Nagano 381-1233 (JP); Ogawa, Mitsue Fujikoshi Machinery Corp., Nagano-shi Nagano 381-1233 (JP)
(74) Representative: Stuart, Ian Alexander

(56) References cited:
- US-A- 4 521 995
- US-A- 5 558 111
- US-B1- 6 193 586
- PATENT ABSTRACTS OF JAPAN vol. 006, no. 052 (E-100), 7 April 1982 (1982-04-07) -& JP 56 164549 A (DISCO ABRASIVE SYS LTD), 17 December 1981 (1981-12-17)
- PATENT ABSTRACTS OF JAPAN vol. 2003, no. 05, 12 May 2003 (2003-05-12) -& JP 2003 011056 A (SHIN ETSU HANDOTAI CO LTD), 15 January 2003 (2003-01-15)

## Description

### BACKGROUND OF THE INVENTION

The present invention relates to a method for polishing wafers, employing a water sucking device. Water is used for adhering a work piece to be polished. A method of sucking water and a water sucking device are employed for sucking excess water from a backing member adhered on one side face of a plate of a polishing apparatus.

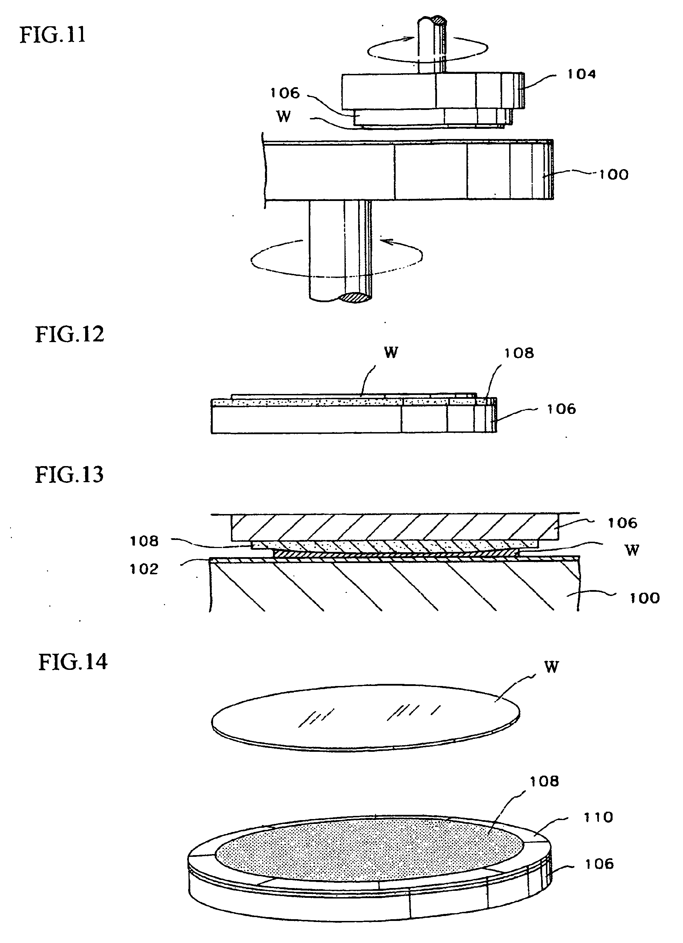

A work piece, e.g., a wafer for producing semiconductor devices, is polished by, for example, a polishing apparatus shown in Fig. 11. In the polishing apparatus shown in Fig. 11, a polishing plate 100, on which a polishing cloth 102 is adhered, is rotated in a prescribed direction. A top ring 104 is rotated in a prescribed direction and moved to and away from the polishing plate 100. A ceramic plate 106 is assembled in a head section of the top ring 104, and a wafer W is held by the plate 106 and pressed onto the polishing cloth 102 so as to polish the wafer W.

As shown in Fig. 12, a backing member 108, which is made of, for example, sheet-shaped resin foam and which is adhered on one side face of the plate 106, includes water, and the wafer W is held on the plate 106 by surface tension of the water.

These days, large and thin wafers W are used, and high polishing accuracy is required.

However, as shown in Fig. 12, a center part of a surface of the polished wafer W, which has been adhered by surface tension of the water included in the backing member adhered on the one side face of the plate 106, is apt to be thinner than an outer edge part thereof.

Namely, the center part of the surface of the polished wafer W is apt to be excessively polished, so that the wafer W is formed into a concave shape. The reason for forming the concave shape will be explained.

When the wafer W is adhered on the backing member 108 with an excessive amount of water and pressed onto the polishing cloth 102 of the polishing plate 100 so as to polish the wafer W, the backing member 108 is pressed by the outer edge part of the wafer W so that the outer edge part of the wafer W seals a space therebetween (see Fig. 13). Therefore, the excess water included in the backing member 108 cannot move to outside of the wafer W, so that the excess water concentrates to the center part of the wafer W.

At that time, temperature of the water included in the backing member 108 is raised by frictional heat caused by polishing, and a center part of the backing member 108, which corresponds to the center part of the wafer W, is made thicker than an outer edge part thereof (see Fig. 13). By firmly pressing the wafer W onto the polishing cloth 102, the wafer W is polished and formed into the concave shape.

Further, if a narrow ring-shaped template 110, which is used for preventing the wafer W so as not to remove from the backing member 108, is adhered on the plate 106 and corresponds to an outer edge of the backing member 108 (see Fig. 14), it is difficult to discharge the excess water existing inside of the template 110.

Unlike the plate 106 having no template, the excess water must be increased in the backing member 108 adhered on the plate 106 having the template 110 shown in Fig. 14.

After the wafer W is polished, the plate 106 is cleaned together with the backing member 108. Therefore, another wafer W to be newly polished is adhered onto the backing member 108 including the excess water.

Namely, the next wafer W is adhered onto the backing member 108 without drying the backing member 108, so it is difficult to adjust water content of the backing member 108 by adjusting amount of supplying water to the backing member 108.

To solve the above described problem, a method of removing excess water of a backing member adhered on a plate is disclosed in Japanese Patent Gazette No. 2003-11056. Namely, water on a holding surface of the backing member, on which the wafer is adhered, is removed by jetting air toward the holding surface of the backing member and/or rotating the plate (please see claims and Fig. 1 of JP 2003-11056).

By jetting air toward the holding surface of the backing member and/or rotating the plate, the water on the backing member can be removed.

However, generally the plate to which the backing member is adhered is cleaned together with the backing member after a wafer is polished, and another wafer is adhered onto the backing member without drying the backing member. Therefore, the backing member still includes the excess water. To remove the excess water by jetting air and/or rotating the plate, several parameters influencing the removal of the excess water, e.g., amount of jetting air, air pressure, a moving speed of an air jet nozzle, a rotational speed of the plate, must be optimized. But, it is difficult to optimize the parameters.

Further, the optimize parameters must be maintained during the polishing, so a control system must be complex.

US 4,521,995 discloses a system that employs water for locating a silicon wafer. Once the wafer is located, air and water may be sucked out via an air sucking hole.

Document US 5 558 111 A discloses a method of polishing a wafer by means of a polishing apparatus having a backing member adhered on a front side face of a carrier plate, said backing member having an exposed holding surface, comprising the steps of:
(a) supplying water to said backing member;
(b) pressing a water absorbing member onto said holding surface of said backing member so as to absorb the excess water from said backing member; sucking the excess water absorbed by said water absorbing member and rotating a polishing plate so as to polish the surface of the wafer and effecting polishing by pressing the rear side face of the carrier plate with a top ring so as to press the wafer onto a polishing cloth adhered on a polishing plate.

### SUMMARY OF THE INVENTION

A preferred embodiment of the present invention may provide a polishing method employing a method of sucking water and a water sucking device, which are capable of easily removing excess water included in a backing member adhered on a plate of the polishing assembly.

The inventors of the present invention studied and found that it is effective to remove the excess water by pressing a water absorbing member onto a holding surface of a backing member, on which a work piece is adhered, and sucking water absorbed by the water absorbing member.

The method of the present invention is a method of polishing a wafer as set out in claim 1.

In the present invention, the plate may have a ring-shaped template, which corresponds to an outer edge of the holding surface of the backing member so as not to remove the work piece from the holding surface of the backing member.

In the present invention, the water absorbing member may be a porous sponge, and the excess water absorbed by the water absorbing member may be vacuum-sucked. With this structure, the excess water included in the backing member can be easily removed.

In the present invention, a size of the water absorbing member may be equal to that of the holding surface of the backing member so as to press the whole holding surface of the backing member. With this structure, the excess water included in the backing member can be effectively removed.

In the present invention, a holder may be moved to and away from the holding surface of the backing member; a holding member may be attached to the holder so as to hold the water absorbing member, the holding member has a plurality of sucking holes for sucking the excess water absorbed by the water absorbing member; and the holder may be moved toward the holding surface of the backing member until the water absorbing member contacts the holding surface of the backing member, then the water absorbing member may be pressed onto the holding surface of the backing member by weight of the holder and the holding member. With this structure, the water sucking device can be simplified.

In the present invention, the water absorbing member is pressed onto the backing member adhered on the plate, so that the water existing on the holding surface of the backing member and the water absorbed in the backing member can be absorbed by the water absorbing member, further the water absorbed by the water absorbing member can be sucked and removed therefrom.

Therefore, the excess water included in the backing member can be easily removed, so that forming the concave shape of the polished work piece, which is caused by the excess water, can be prevented. Accuracy of polishing the surface of the work piece can be improved.

Further, the parameters influencing the removal of the excess water can be easily optimized, and a control system for maintaining the optimum parameters can be simplified.

### BRIEF DESCRIPTION OF THE DRAWINGS

Embodiments of the present invention will now be described by way of examples and with reference to the accompanying drawings, in which:
Fig. 1 is a front view of a water sucking device suitable for use in a method which is an embodiment of the present invention;
Fig. 2 is a sectional view of the water sucking device shown in Fig. 1;
Fig. 3 A is a plan view of a distribution plate of the water sucking device;
Fig. 3 B is a rear view of the distribution plate;
Fig. 4 is a partial sectional view of a polishing apparatus polishing a work piece adhered on a backing member, whose excess water has been sucked by the water sucking device;
Fig. 5 is a partial plan view of a positioning mechanism for positioning a plate 10 shown in Fig. 4;
Fig. 6 and 7 are graphs showing an effect of removing excess water from the backing member;
Fig. 8 is a perspective view of a water sucking device for use in another embodiment of the present invention;
Fig. 9 is a partial sectional view of the water sucking device shown in Fig. 8;
Fig. 10 is a schematic view of a drain separator provided between the water sucking device and a vacuum pump;
Fig. 11 is an explanation view of the conventional polishing apparatus;
Fig. 12 is a front view of the plate used in the polishing apparatus shown in Fig. 11;
Fig. 13 is an explanation view of polishing a wafer W, which is an example of the work piece; and
Fig. 14 is a perspective view of another plate used in the polishing apparatus shown in Fig. 11.

### DETAILED DESCRIPTION OF THE EMBODIMENTS

Preferred embodiments of the present invention will now be described in detail with reference to the accompanying drawings.

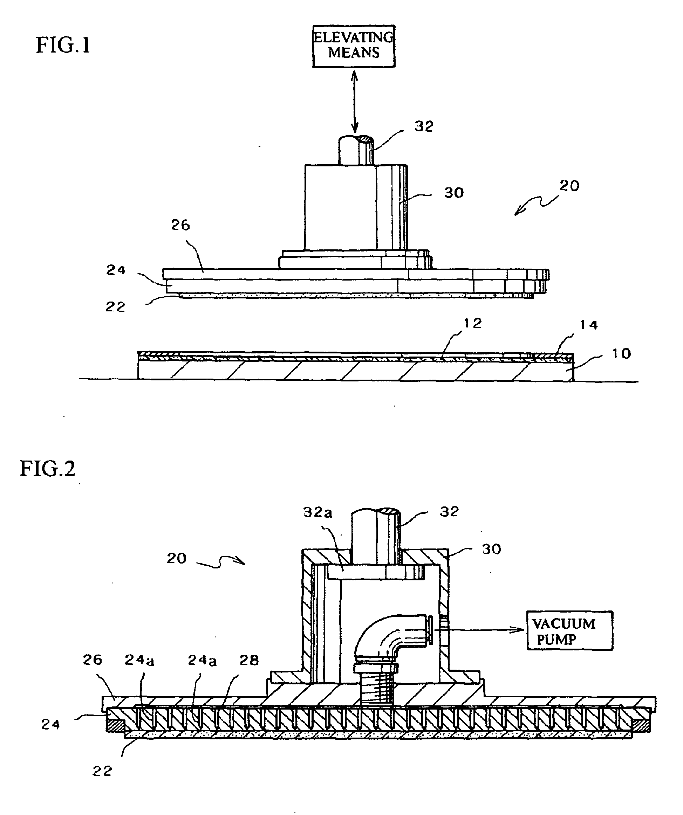

A water sucking device used in an embodiment of the present invention is shown in Fig. 1. In Fig. 1, a backing member 12, which is made of, for example, sheet-shaped resin foam, is adhered on an upper face of a ceramic plate 10. A narrow ring-shaped template 14 is adhered on the plate 10, and the template 14 is provided along an outer edge of the backing member 12, on which a wafer W, which is an example of a work piece, is held.

The water sucking device 20 has a water absorbing member 22, which is made of, for example, a porous sponge and which is capable of covering a whole holding surface of the backing member 12. The wafer W to be polished is held on the holding face of the backing member 12. For example, the water absorbing member 22 may be made of polyvinyl alcohol (PVA).

The water sucking device 20 has a holding plate 24 for holding the water absorbing member 22, and a holder 26, which holds the holding plate 24 and which is moved to and away from the holding surface of the backing member 12. The holder 26 is moved by elevating means, e.g., a cylinder unit.

As shown in Fig. 2, the holding plate 24 has a plurality of sucking holes 24a, and air is sucked, through the sucking holes 24a, by a vacuum pump. Namely, the water absorbing member 22 is held by the holding plate 24, and water absorbed in the water absorbing member 22 is sucked and removed through the sucking holes 24a.

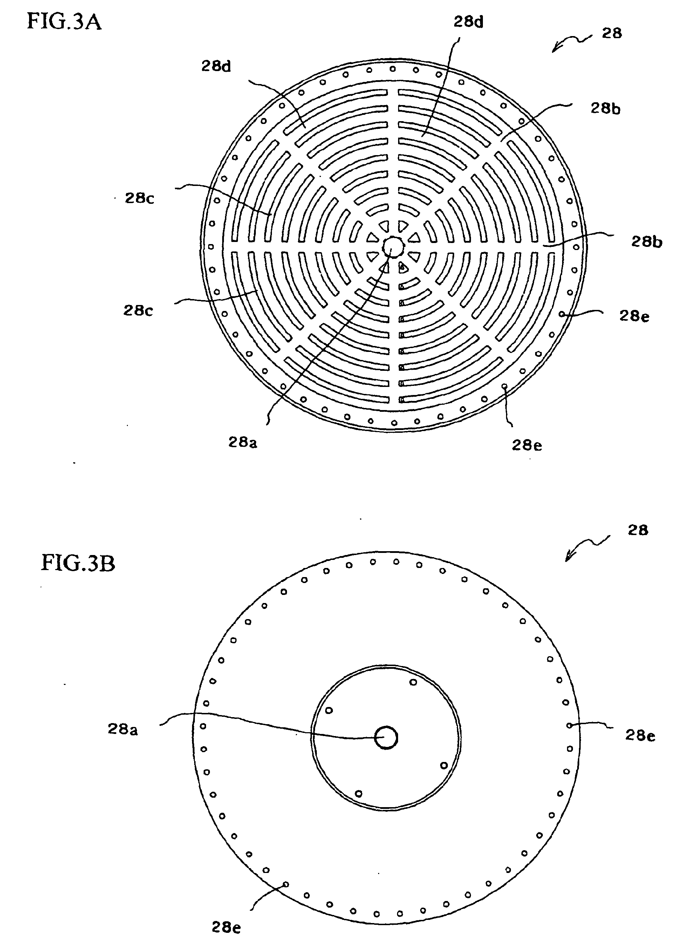

A tube communicating with the vacuum pump is connected to a center part of the holding plate 24. In the water sucking device 20 shown in Figs. 1 and 2, a distribution plate 28, which is made of rubber, is provided between the holding plate 24 and the holder 26 (see Figs. 3 A and 3 B). By using the distribution plate 28, water can be uniformly sucked via the sucking holes 24a.

Note that, the distribution plate 28 may be made of other materials, e.g., polyvinyl chloride, stainless steel.

Fig. 3 A is a plan view of the distribution plate 28 seen from the holding plate 24 side, and Fig. 3 B is a rear view of the distribution plate 28 seen from the holder 26 side.

As shown in Figs. 3 A and 3 B, an outlet hole 28a is formed at a center part of the distribution plate 28. A plurality of grooves 28b are formed in a lower face of the distribution plate 28. The grooves 28b are radially extended from the outlet hole 28a. Projected lines 28c and grooves 28d are alternately arranged between the adjacent grooves 28b. Further, the projected lines 28c and the grooves 28d are arranged like concentric circles.

By using the distribution plate 28, air and water sucked through the sucking holes 24a of the holding plate 24 are sucked and introduced to the vacuum pump via the grooves 28b and 28d, the outlet hole 28a and the tube connected to the outlet hole 28a and the vacuum pump.

With this structure, bypassing from the sucking holes 24a to the outlet hole 28a can be prevented, so that the air and the water can be uniformly sucked via the sucking holes 24a.

Note that, small holes 28e are bored in an outer edge part of the distribution plate 28. By sinking screws into the small holes 28e, the distribution plate 28 can be attached to the holding plate 24.

In the water sucking device 20 shown in Figs. 1 and 2, the holding plate 24 and the holder 26 are heavy, so the water absorbing member 22 can be pressed onto the holding surface of the backing member 12 of the plate 10 by weight of the holding plate 24 and the holder 26. A cylindrical section 30 of the holder 26 shown in Fig. 2 is not fixed to a shaft 32 connected to the elevating means. Therefore, the elevating means does not press the absorbing member 22, which contacts the holding surface of the backing member 12 of the plate 10.

Note that, if a flange 32a of the shaft 32 contacts a ceiling face of the cylindrical section 30, the water sucking device 20 is vertically moved by the elevating means.

The water sucking device 20 shown in Figs. 1 and 2 is moved downward by the elevating means. Since the water absorbing member 22 is held by the holding plate 24, the water absorbing member 22 contacts the holding surface of the backing member 12 of the plate 10, which has been mounted on a table, then the water absorbing member 22 is pressed onto the backing member 12 by the weight of the holding plate 24 and the holder 26.

When the absorbing member 22 is pressed, the water absorbing member 22 deforms to correspond to the holding surface of the backing member 12. Therefore, the holding surface of the backing member 12, which is located inside of the template 14, can be pressed.

By pressing the whole holding surface of the backing member 12 with the water absorbing member 22, water stuck on the holding surface of the backing member 12 and water penetrated in the backing member 12 can be absorbed by the water absorbing member 22.

Further, the water absorbed by the water absorbing member 22 is sucked and removed from the absorbing member 22 by the vacuum pump via the sucking holes 24a of the holding plate.

After pressing the water absorbing member 22 on the whole holding surface of the backing member 12, which is adhered to the plate 10, for a prescribed time, the water sucking device 20 is moved upward by the elevating means, so that the excess water in the backing member 12 can be completely removed.

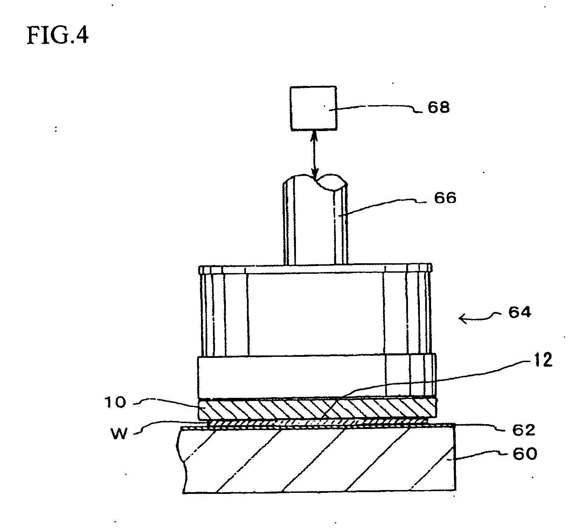

The work piece, e.g., the wafer W, is adhered onto the holding surface of the backing member 12, from which the excess water has been removed, by surface tension of water, then the wafer W is polished by a polishing apparatus shown in Fig. 4. In the polishing apparatus shown in Fig. 4, a lower surface of the wafer W is pressed onto a polishing cloth 62 adhered on a polishing plate 60, with the backing member 12 adhered on the lower face of the plate 10, by top ring 64, which contacts the upper face of the plate 10, so that the lower face of the wafer W can be polished.

The top ring 64 is connected to moving means 68 by a shaft 66. With this structure, the top ring 64 can be moved to and away from the upper face of the plate 10.

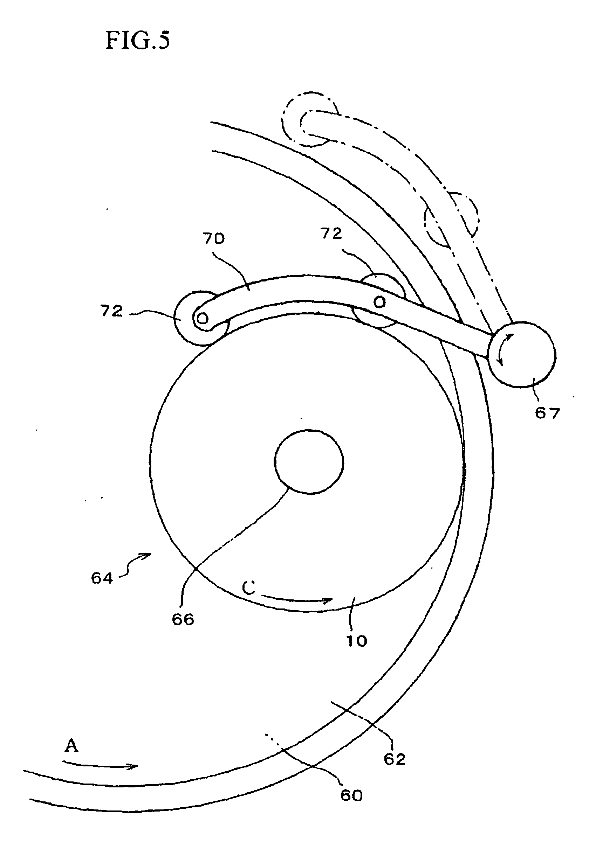

The plate 10, to which the wafer W, which is pressed onto the polishing cloth 62 of the polishing plate 60, is adhered, is positioned at a predetermined position in the polishing plate 60 by two rollers 72 (see Fig. 5).

The rollers 72 are attached to an arm 70, whose one end is pivotably attached to a base section located outside of the polishing plate 60 rotating in a direction A. The rollers 72 contact two points of the plate 10, which is rotated in the direction A together with the polishing plate 60.

Note that, when the plate 10 is not positioned at the predetermined position, a pivot shaft 67 of the arm 70 can be turned to move the rollers 72 toward outside of the polishing plate 60.

In Fig. 5, the plate 10 is positioned at the predetermined position by two rollers 72 carried by the arm 70. In another embodiment (not illustrated), the plate 10 can be positioned at the predetermined position in the polishing plate 60 by one roller which is attached to an arm, and by a central roller. The roller on the arm and the central roller contact two points of an outer circumferential face of the plate 10, which is rotated in the direction A together with the polishing plate 60, so that the plate 10 can be positioned at the predetermined position.

The inventors performed experiments. Firstly, the excess water included in the backing member 12, which was adhered on the plate 10, was sucked by the water sucking device 20 shown in Figs. 1 and 2. Then, the wafer W was adhered onto the holding surface of the backing member 12 and polished by the polishing apparatus shown in Figs. 4 and 5.

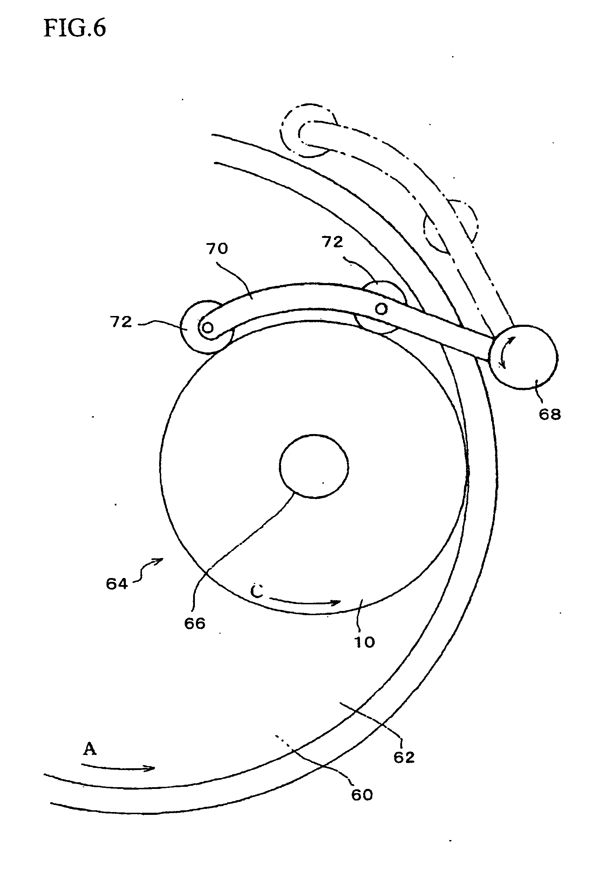

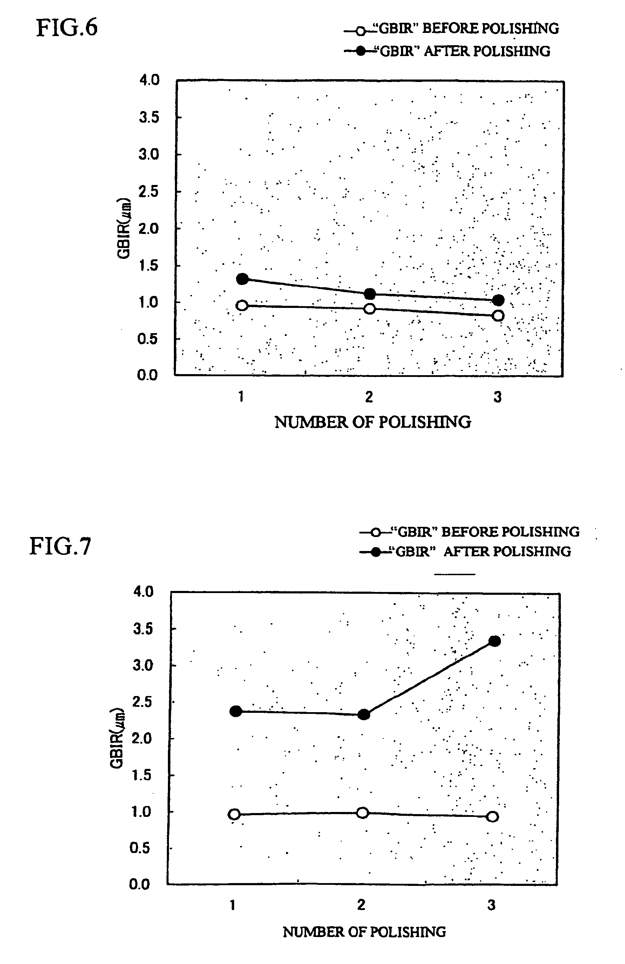

The steps of sucking the excess water and polishing the wafer W were repeated several times with the same backing member 12. In each time, thickness (distance from an upper standard surface) was measured at several points in the polished wafer W, and the GBIRs between a maximal value and a minimal value were calculated. The results are shown in Fig. 6.

Further, the wafer W was similarly polished, but excess water was not removed from the backing member 12. The polishing was repeated several times with the same backing member 12. In each time, thickness (distance from an upper standard surface) was measured at several points in the polished wafer W, and the GBIRs between a maximal value and a minimal value were calculated. The results are shown in Fig. 7.

In Figs. 6 and 7, horizontal axes indicate number of the polishing operations, and the vertical axes indicate the GBIRs.

According to Figs. 6 and 7, the flatness of the polished wafer W could be improved by polishing the wafer W after removing the excess water from the backing member 12. Further, the flatness of the polished wafer W could be maintained in spite of repeatedly using the same backing member 12. The reason will be explained.

In the conventional polishing apparatus, as described above with reference to Fig. 13, the excess water concentrates to the center part of the wafer W, so that the center part of the backing member 108 is made thicker than the outer edge part thereof. This phenomenon causes the concave shape of the polished wafer W. On the other hand, in the present invention, the problem can be solved by sucking the excess water included in the backing member 12. Therefore, polishing accuracy can be improved.

In the present embodiment, the water sucking device 20 shown in Fig. 1 can be correctly positioned with respect to the plate 10. Thus, area of the surface of the water absorbing member 22 is equal to that of the holding surface of the backing member 12, which is exposed inside of the template 14.

If it is difficult to correctly position the water sucking device 20 with respect to the plate 10, the surface of the water absorbing member 22 may be broader than the holding surface of the backing member 12, which is exposed inside of the template 14.

In the water sucking device 20 shown in Figs. 1 and 2, the water absorbing member 22 is pressed onto the holding surface of the backing member 12 of the plate 10 by the weight of the holding plate 24 and the holder 26. If the weight is insufficient, the elevating means, which moves the water sucking device 20 upward and downward, may compulsorily press the water absorbing member 22 onto the backing member 12. In this case, the cylindrical section 30 of the holder 26 (see Fig. 2) is fixed to the shaft 32 connected to the elevating means.

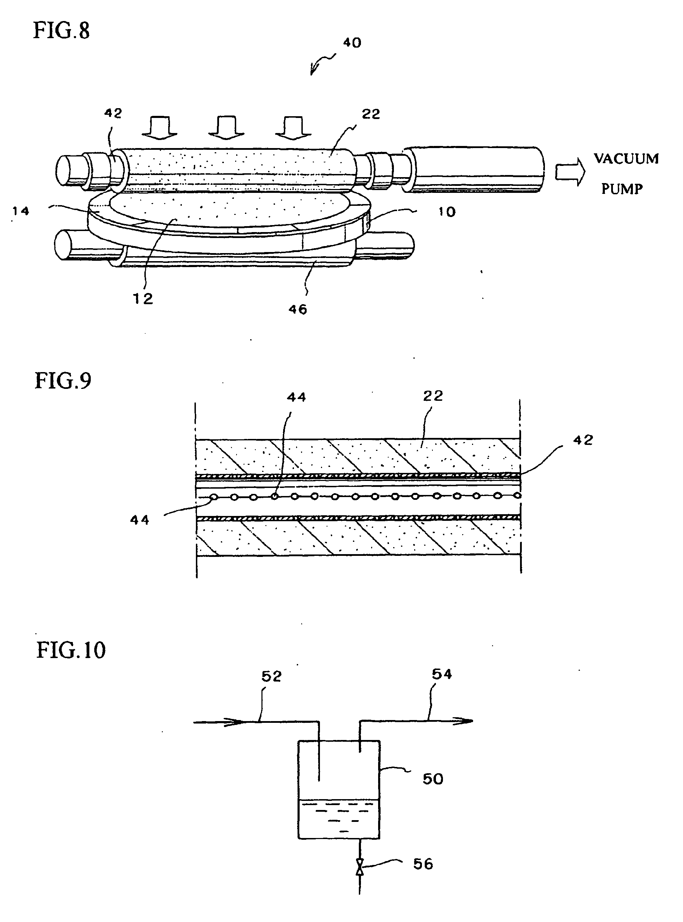

Successively, another embodiment of the water sucking method will be explained with respect to Figs. 8 and 9. This employs a water sucking device 40 which is a roller type water sucking device. The plate 10 is conveyed by a conveyor roller 46. The water sucking device 40 has the water absorbing member 22, which is made of, for example, a porous sponge and which is attached on an outer circumferential face of a rotatable cylindrical member 42.

As shown in Fig. 9, the cylindrical member 42 has a plurality of sucking holes 44. By sucking air in the cylindrical member 42 by a vacuum pump, the water absorbing member 22 can be held on the outer circumferential face of the cylindrical member 42, and excess water absorbed in the water absorbing member 22 can be sucked and remove.

The water sucking device 40 is provided above the conveyor roller 46. The water absorbing member 22, which is rotated together with the cylindrical member 42, contacts the holding surface of the backing member 12 of the plate 10, which has been conveyed by the conveyor roller 46. Further, the water absorbing member 22 is pressed onto the holding surface of the backing member 12.

The water stuck on the holding surface of the backing member 12 and water penetrated in the backing member 12 can be absorbed by the water absorbing member 22, and the water absorbed in the water absorbing member 22 is sucked and removed therefrom by the vacuum pump.

The water sucking device 40 shown in Fig. 8 is fixed at position above the roller conveyor 46. In another case, the water sucking device 40 may be moved along the holding surface of the backing member 12 after the plate 10 is conveyed to and set at a predetermined position. In this case too, the water absorbing member 22 is rotated and pressed onto the holding surface of the backing member 12.

In the water sucking devices shown in Figs. 1-3 and 8, the water absorbed in the water absorbing members 22 are sucked by the vacuum pumps. Preferably, the vacuum pumps are water ring vacuum pumps, which are capable of sucking water.

In case of using an ordinary vacuum pump, troubles will be occurred by sucked water. To solve this problem, a drain separator shown in Fig. 10 may be provided between the water sucking device and the vacuum pump. The drain separator includes a drain pot 50, which is connected to a tube 52 connected to the water sucking device and a tube 54 connected to the vacuum pump. A purge valve 56 is connected to the drain pot 50 so as to purge water from the drain pot 50.

When an air stream including water, which is sent via the tube 52, enters the drain pot 50, a speed of the air stream is suddenly reduced so that the water is separated from the air and stored in the drain pot 50. Therefore, the air only can be sucked by the vacuum pump via the tube 54.

As described above, the plate 10 having the backing member 12, from which the excess water has been removed by the water sucking device and the method of the present invention, can be used in the polishing apparatus shown in Figs. 4 and 5. In the polishing apparatus, the plate 10 having the backing member 12 is correctly positioned at the predetermined position by the rollers 72. To polish the lower surface of the wafer W, which is adhered on the lower face of the backing member 12 of the plate 10, the wafer W is pressed onto the polishing cloth 62 adhered on the polishing plate 60 by pressing force of the top ring 64.

The water sucking method of the present invention may be employed in the polishing apparatuses. For example, the present invention may be applied to the polishing apparatus shown in Fig. 11. In the polishing apparatus shown in Fig. 11, the wafer W is held on the ceramic plate 106, which is fixed in the head section of the rotatable top ring 104. The top ring 104 is rotated in a prescribed direction and moved to and away from the polishing cloth 102 adhered on the polishing plate 100. The top ring 104 presses the wafer W onto the polishing cloth 102, so that the lower surface of the wafer W can be polished.

## Claims

1. A method of polishing a wafer by means of a polishing apparatus having a backing member (12) adhered on a front side face of a carrier plate (10), said backing member (12) having an exposed holding surface,
comprising the steps of:
(a) supplying water to said backing member (12)
(b) pressing a water absorbing member (22) onto said holding surface of said backing member (12), so as to absorb the excess water from said backing member (12); and sucking the excess water absorbed by said water absorbing member. (22)
(c) adhering a wafer (W) onto said holding surface by surface tension after said absorption of excess water; and effecting polishing by pressing the rear side face of the carrier plate (10) with a top ring (64) so as to press the wafer (W) onto a polishing cloth (62) adhered on a polishing plate (60); and rotating the polishing plate (60) so as to polish the surface of the wafer (W).

2. The method according to claim 1,
wherein said plate has a ring-shaped template (14), which corresponds to an outer edge of the holding surface of said backing member (12) so as not to remove the work piece from the holding surface of said backing member (12).

3. The method according to claim 1,
wherein said water absorbing member (22) is a porous sponge.

4. The method according to claim 1,
wherein the excess water absorbed by said water absorbing member (22) is vacuum-sucked.

5. The method according to claim 1,
wherein a size of said water absorbing member (22) is equal to that of the holding surface of said backing member (12) so as to press the whole holding surface of said backing member (12).

6. The method according to claim 1,
wherein a holder (26) is moved to and away from the holding surface of said backing member (12),
a holding member is attached to the holder (26) so as to hold said water absorbing member (22), the holding member has a plurality of sucking holes (24a) for sucking the excess water absorbed by said water absorbing member (22), and
the holder (26) is moved toward the holding surface of said backing member (12) until said water absorbing member (22) contacts the holding surface of said backing member (12), then the water absorbing member (22) is pressed onto the holding surface of the backing member (12) by weight of the holder (26) and the holding member.

## Patentansprüche

1. Verfahren zum Polieren eines Wafers durch eine Poliervorrichtung mit einem Stützelement (12), das an einer vorderen Seitenfläche einer Trägerplatte (10) befestigt ist, wobei das Stützelement (12) eine frei liegende Haltefläche aufweist,
wobei das Verfahren folgende Schritte umfasst:
(a) das Zuführen von Wasser zu dem Stützelement (12)
(b) das Drücken eines wasserabsorbierenden Elements (22) auf die Haltefläche des Stützelements (12), um das überschüssige Wasser von dem Stützelement (12) zu absorbieren, und das Aufsaugen des durch das wasserabsorbierende Element (22) absorbierten, überschüssigen Wassers
(c) das Anhaften eines Wafers (W) auf der Haltefläche mit Hilfe von Oberflächenspannung nach der Absorption des überschüssigen Wassers und das Durchführen des Polierens, indem die hintere Seitenfläche der Trägerplatte (10) mit einem oberen Ring (64) gedrückt wird, um den Wafer (W) auf ein Poliertuch (62) zu drücken, das an einer Polierplatte (60) anhaftet, und das Drehen der Polierplatte (60), um die Oberfläche des Wafers (W) zu polieren.

2. Verfahren nach Anspruch 1,
worin die Platte eine ringförmige Schablone (14) aufweist, die einem Außenrand der Haltefläche des Stützelements (12) entspricht, um das Arbeitsstück nicht von der Haltefläche des Stützelements (12) zu entfernen.

3. Verfahren nach Anspruch 1,
worin das wasserabsorbierende Element (22) ein poröser Schwamm ist.

4. Verfahren nach Anspruch 1,
worin das überschüssige Wasser, das durch das wasserabsorbierende Element (22) absorbiert wird, mit Hilfe von Vakuum aufgesaugt wird.

5. Verfahren nach Anspruch 1,
worin die Größe des wasserabsorbierenden Elements (22) jener der Haltefläche des Stützelements (12) entspricht, damit es auf die gesamte Haltefläche des Stützelements (12) gedrückt werden kann.

6. Verfahren nach Anspruch 1,
worin eine Haltevorrichtung (26) auf die Haltefläche des Stützelements (12) zu und von dieser weg bewegt wird,
ein Halteelement an der Haltevorrichtung (26) befestigt ist, um das wasserabsorbierende Element (22) zu halten, wobei das Halteelement eine Vielzahl an Sauglöchern (24a) aufweist, um das überschüssige Wasser abzusaugen, das durch das wasserabsorbierende Element (22) absorbiert wird, und
die Haltevorrichtung (26) auf die Haltefläche des Stützelements (12) zu bewegt wird, bis das wasserabsorbierende Element (22) die Haltefläche des Stützelements (12) berührt, wonach das wasserabsorbierende Element (22) durch das Gewicht der Haltevorrichtung (26) und das Halteelement auf die Haltefläche des Stützelements (12) gedrückt wird.

## Revendications

1. Procédé de polissage d'une tranche au moyen d'un appareil de polissage comportant un élément d'appui (12) collé sur une face côté avant d'une plaque de support (10), ledit élément d'appui (12) comportant une surface de support exposée,
comprenant les étapes consistant à :
(a) fournir de l'eau au dit élément d'appui (12),
(b) presser un élément d'absorption d'eau (22) sur ladite surface de support dudit élément d'appui (12), de manière à absorber l'eau excédentaire dudit élément d'appui (12) ; et aspirer l'eau excédentaire absorbée par ledit élément d'absorption d'eau (22),
(c) coller une tranche (W) sur ladite surface de support par tension superficielle après ladite absorption de l'eau excédentaire ; et effectuer le polissage en pressant la face côté arrière de la plaque de support (10) avec une bague supérieure (64) de manière à presser la tranche (W) sur un tissu de polissage (62) collé sur une plaque de polissage (60) ; et faire tourner la plaque de polissage (60) de manière à polir la surface de la tranche (W).

2. Procédé selon la revendication 1,
dans lequel ladite plaque comporte un gabarit en forme de bague (14), qui correspond à un bord extérieur de la surface de support dudit élément d'appui (12) de manière à ne pas retirer la pièce de fabrication de la surface de support dudit élément d'appui (12).

3. Procédé selon la revendication 1,
dans lequel ledit élément d'absorption d'eau (22) est une éponge poreuse.

4. Procédé selon la revendication 1,
dans lequel l'eau excédentaire absorbée par ledit élément d'absorption d'eau (22) est aspirée par vide.

5. Procédé selon la revendication 1,
dans lequel une taille dudit élément d'absorption d'eau (22) est égale à celle de la surface de support dudit élément d'appui (12) de manière à presser la surface de support entière dudit élément d'appui (12).

6. Procédé selon la revendication 1,
dans lequel un support (26) est rapproché et éloigné de la surface de support dudit élément d'appui (12),
un élément de support est fixé au support (26) de manière à supporter ledit élément d'absorption d'eau (22), l'élément de support comporte une pluralité de trous d'aspiration (24a) pour aspirer l'eau excédentaire absorbée par ledit élément d'absorption d'eau (22), et
le support (26) est rapproché de la surface de support dudit élément d'appui (12) jusqu'à ce que ledit élément d'absorption d'eau (22) vienne en contact avec la surface de support dudit élément d'appui (12), ensuite l'élément d'absorption d'eau (22) est pressé sur la surface de support de l'élément d'appui (12) par le poids du support (26) et de l'élément de support.
